# EUROPEAN PATENT APPLICATION

(11) **EP 4 776 834 A1**
(43) Date of publication of application: **15.07.2026**
(21) Application number: 25218442.9
(22) Date of filing: 25.11.2025
(51) Int. Cl.: H10W 40/25, H10W 40/20, H10W 90/20, H10W 80/00, H10W 20/40, H10W 42/00

(54) **INTEGRATED CIRCUITS WITH THERMAL MANAGEMENT LAYERS FOR IMPROVED HEAT DISSIPATION**

(30) Priority: 27.12.2024 US 202419003279
(71) Applicant: INTEL Corporation, Santa Clara, CA 95054 (US)
(72) Inventor: PANTUSO, Daniel, Portland, 97229 (US); JIANG, Lei, Camas, 98607 (US); RAMAYYA, Edwin B., Beaverton, 97007 (US); LANDON, Colin D., Portland, 97229 (US); D'SILVA, Joseph, Hillsboro, 97124 (US); KOBRINSKY, Mauro J., Portland, 97229 (US)
(74) Representative: 2SPL Patentanwälte PartG mbB

(57) **Abstract**

Techniques are provided herein to form semiconductor dies with a thermally conductive bond interface to enhance the thermal dissipation from the semiconductor devices. A frontside interconnect region is provided above a semiconductor device layer to, for example, route signals between various semiconductor devices in the device layer. A thermally conductive bond layer may be provided above the frontside interconnect region, such as on a top-most layer of the frontside interconnect region. The thermally conductive bond layer includes a metal such as titanium, ruthenium, copper, or generally any material having a thermal conductivity of at least 1.5 W/m·K. The bond layer may be formed on a material layer that is deposited first on the frontside interconnect region. The material layer may be any of diamond, silicon carbide, copper, or aluminum nitride, to name a few examples.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, parasitic effects caused by heat can increasingly impact the device operation in an undesirable way. Accordingly, there remain a number of non-trivial challenges with respect to forming semiconductor devices.

### BRIEF DESCRIPTION OF THE DRAWINGS

Figure 1 is a cross-sectional view of die bonded to a package substrate with a heat sink.
Figure 2A - 2E are cross-sectional views of dies having a thermally conductive bond layer in various arrangements, in accordance with some embodiments of the present disclosure.
Figures 3A - 3F are cross-sectional views that illustrate various stages in an example process for fabricating a die having a carrier wafer bonded using a thermally conductive bond interface, in accordance with some embodiments of the present disclosure.
Figure 4 illustrates a computing system including one or more dies, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topography or otherwise be non-smooth, given real world limitations of the processing equipment and techniques used.

### DETAILED DESCRIPTION

Techniques are provided herein to form semiconductor dies with a thermally conductive bond interface to enhance the thermal dissipation from the semiconductor devices. The techniques can be used in any number of integrated circuit applications. A semiconductor die includes any number of semiconductor devices within a device layer. A frontside interconnect region is provided above the device layer to, for example, route signals between the various semiconductor devices in the device layer. A thermally conductive bond layer may be provided above the frontside interconnect region, such as on a topmost layer of the frontside interconnect region. According to some embodiments, the thermally conductive bond layer includes a metal such as titanium, ruthenium, copper, or generally any material having a thermal conductivity of at least 1.5 W/m·K, at least 15 W/m·K, at least 100 W/m·K, or at least 300 W/m·K. The bond layer may be formed on a material layer that is deposited first on the frontside interconnect region. The material layer may be, for instance, any of diamond, silicon carbide, copper, or aluminum nitride, to name a few examples. According to some embodiments, the material layer includes a material having a thermal conductivity of at least 1.5 W/m·K, at least 15 W/m·K, at least 100 W/m·K, or at least 300 W/m·K. The presence of the thermally conductive bond layer provides greater heat dissipation up through the layer stack, such as from the semiconductor device layer and through the frontside interconnect region towards a heat sink arranged on top of the die, according to some embodiments. Numerous variations and embodiments will be apparent in light of this disclosure.

### General Overview

As previously noted above, there remain a number of non-trivial challenges with respect to integrated circuit fabrication. In more detail, as devices become smaller and more densely packed, heat dissipation from the devices increasingly becomes a challenge. Thermal conduction between the semiconductor devices within a device layer and a heat sink (e.g., a carrier wafer and/or metal structure on the carrier wafer) for a die with backside interconnects is limited by the thermal resistance of the bond layer that mechanically connects the frontside interconnect region of the die to the carrier wafer. This bond is often a fusion bond between a planarized silicon dioxide layer on the interconnect region and a thermally grown silicon dioxide layer on the carrier wafer. These bond materials are in the heat conduction path between the devices and the heat sink, and the heat conduction is especially limited in devices using backside contacts for power delivery due to the lack of a semiconductor substrate beneath the devices. The bond materials used in conventional device designs are poor thermal conductors and thus transistor cooling is not as efficient as, for example, technologies that are based on front-side power delivery.

Thus, techniques are provided herein to form a thermally conductive bond interface between a carrier substrate and a remainder of the die having the semiconductor devices in order to reduce the thermal resistance in the heat path between the devices and the heat sink, according to some embodiments. The die includes multiple different layers, including a device layer having a plurality of semiconductor devices (e.g., transistors). Beneath the device layer, the substrate has been removed and replaced with a backside interconnect region having one or more backside interconnect layers. The one or more backside interconnect layers may be used to route power or signals to the underside of various transistor elements of the device layer, such as the underside of source or drain regions and/or the underside of gate structures, or to through-via structures for connecting to the topside of transistor elements. A frontside interconnect region may be provided above the device layer and includes any number of frontside interconnect layers. The frontside interconnect layers may be used to route signals between any of the semiconductor devices.

A bond interface is between a top surface of the frontside interconnect region and a surface of a carrier wafer in order to bond the carrier wafer to the rest of the die. According to some embodiments, the bond interface includes a thermally conductive bond layer that may be a metal, such as any of titanium, ruthenium, or copper. The bond layer may have a thermal conductivity of at least 1.5 W/m·K, 5 W/m·K, at least 15 W/m·K, at least 100 W/m·K, or at least 300 W/m·K. The bond layer may generally be made thinner (e.g., around 1 µm or less than 1 µm) compared to conventional bonding layers. According to some embodiments, a material layer having a thermal conductivity of at least 1.5 W/m·K, at least 10 W/m·K, at least 100 W/m·K, at least 300 W/m·K, or generally higher than the thermal conductivity of silicon dioxide, is present between the bond layer and the top of the frontside interconnect region. Example materials for the material layer include silicon carbide, aluminum nitride, diamond, copper, or boron nitride. According to some embodiments, the material layer is deposited onto a non-planar top surface of the frontside interconnect region (e.g., having a roughness variation greater than 50 nm, or greater than 100 nm) and has a substantially planar top-side surface with roughness variation of less than 1 nm or less than 2 nm. In some examples, the material layer is a first material layer and a second material layer is formed between the bond layer and the first material layer. The second material layer may have a relatively low dielectric constant (e.g., a dielectric constant of less than 7.0) to reduce parasitic capacitance from the bond layer.

According to an embodiment, a die includes a plurality of semiconductor devices, an interconnect region above the plurality of semiconductor devices and having a plurality of interconnect layers, a bond layer over the interconnect region, and a substrate on the bond layer. The bond layer has a thermal conductivity of, for example, at least 5 W/m·K.

According to another embodiment, an electronic device includes a chip package having one or more dies. At least one of the one or more dies includes a device layer comprising one or more semiconductor devices, one or more interconnect layers above the device layer, a material layer on a top surface of a topmost interconnect layer of the one or more interconnect layers, a bond layer over the material layer, and a substrate bonded to the bond layer. The bond layer has a thermal conductivity of, for example, at least 5 W/m·K and the material layer have a thermal conductivity of, for example, at least 10 W/m·K.

According to another embodiment, a die includes a device layer comprising one or more semiconductor devices, an interconnect region above the plurality of semiconductor devices and having a plurality of interconnect layers, a first material layer on a top surface of a topmost interconnect layer of the plurality of interconnect layers, a second material layer on a top surface of the first material layer, a metal layer on a top surface of the second material layer, and a substrate on the metal layer. The first material layer has a thermal conductivity of, for example, at least 10 W/m·K. The second material layer has a dielectric constant of less than 7.0.

The techniques can be used with any type of transistors, including both planar or non-planar transistors. Non-planar transistors include finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a high-thermally conductive material (e.g., silicon carbide, diamond, aluminum nitride, or boron nitride) at or adjacent to a bond interface between a carrier substrate and an interconnect region above a semiconductor device layer. In another example, such tools may indicate that the bond material itself is a metal or a metal oxide containing any of titanium, ruthenium, or copper.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. A layer may partially or completely fill a given recess or space or volume. A space or volume that is at least partially within a given layer and devoid of any solid fill materials may be referred to herein as an airgap or a void (used interchangeably herein). Such an airgap or void may be filled with one or more gasses (e.g., oxygen, nitrogen, air, to name a few examples), or be devoid of any gases.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

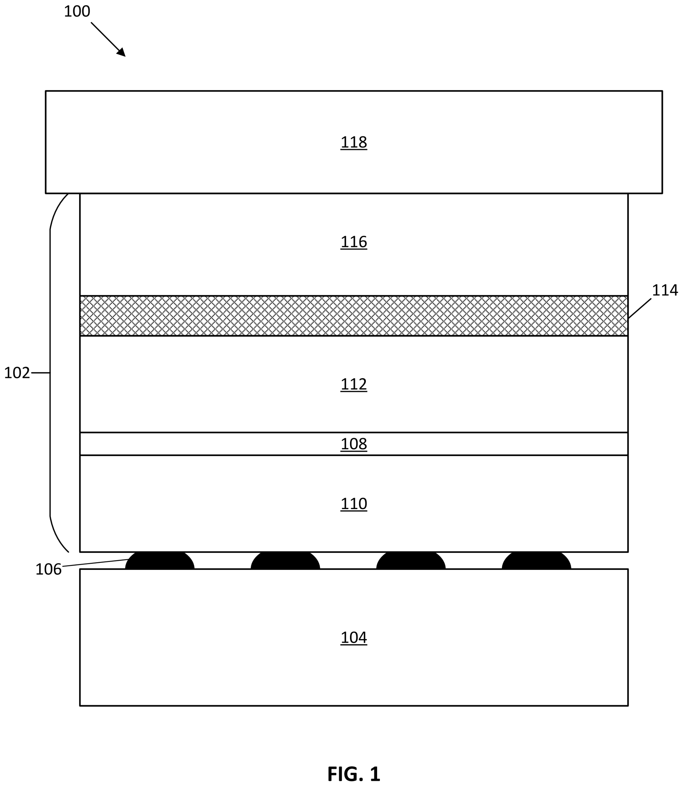

Figure 1 is a cross-sectional view taken across a chip package 100 having an example die 102. Die 102 is bonded to a package substrate 104 using connections 106, which may be implemented with any number of standard or proprietary connection mechanisms, such as solder bumps, ball grid array (BGA), pins, or wire bonds, to name a few examples. Package substrate 104 may be any standard or proprietary package substrate, but in some cases includes a dielectric material having conductive pathways (e.g., including conductive vias and lines) extending through the dielectric material between the faces of package substrate 104, or between different locations on each face. Package substrate 104 may have a thickness less than 1 millimeter (e.g., between 0.1 millimeters and 0.5 millimeters), although any number of package geometries can be used. In some examples, package substrate 104 is thicker, such as greater than 1.5 mm thick.

Die 102 includes a device layer 108 between a backside interconnect region 110 and a frontside interconnect region 112. Device layer 108 includes any number of semiconductor devices. The semiconductor devices may be planar devices, or non-planar metal oxide semiconductor (MOS) transistors, such as tri-gate (e.g., finFET) or gate-all-around (GAA) transistors. Other devices may be present as well within device layer 108, such as diodes, resistors, or capacitors. Backside interconnect region 110 may include any number of dielectric interconnect layers having any number of conductive vias and conductive lines to couple to the underside of elements from any of the semiconductor devices in device layer 108. In some examples, backside interconnect region 110 includes one or more conductive lines that act as power or ground rails. Frontside interconnect region 112 may include any number of dielectric interconnect layers having any number of conductive vias and conductive lines to couple to the top side of elements from any of the semiconductor devices in device layer 108. In some examples, frontside interconnect region 112 includes one or more conductive lines that carry signals between different devices in device layer 108.

A bond layer 114 is provided between the top of frontside interconnect region 112 and a carrier substrate 116. Carrier substrate 116 may be a semiconductor substrate, such as a silicon or silicon germanium substrate, although other substrate materials may be used as well. Carrier substrate 116 is significantly thicker compared to the combined thickness of backside interconnect region 110, device layer 108, and frontside interconnect region 112. For example, the combined thickness of backside interconnect region 110, device layer 108, and frontside interconnect region 112 may be on the order of a few micrometers, such as between 1 micrometer and 5 micrometers, while the thickness of carrier substrate 116 is on the order of tens of micrometers or hundreds of micrometers, such as between 50 micrometers and 800 micrometers. Bond layer 114 may also be on the order of a few micrometers thick, such as between 1 micrometer and 10 micrometers. A heat sink 118 may be arranged on a top surface of carrier substrate 116 to dissipate heat conducted through carrier substrate 116.

In conventional devices, bond layer 114 is formed via a fusion bond between layers of dielectric material, such as between layers of silicon dioxide. While this leads to a strong bond with carrier substrate 116, the material is a poor thermal conductor. As a result, heat generated from the semiconductor devices in device layer 108 cannot dissipate as easily through the various layers above device layer 108 to reach heat sink 118. The additional heat retention limits how densely the devices can be arranged and also limits the devices' operating frequencies.

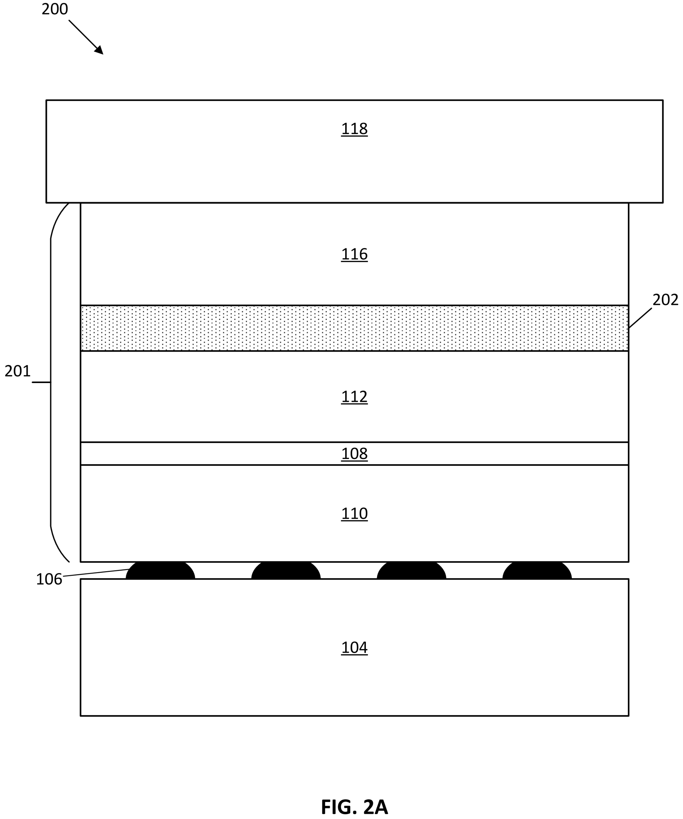

Figure 2A illustrates another cross-section of a chip package 200 having a die 201 with a bond layer 202 with a relatively high thermal conductivity, according to some embodiments. Bond layer 202 may include a conductive material, such as a metal. In some examples, bond layer 202 includes titanium, ruthenium, or copper. In some examples, bond layer 202 includes a non-metal material with a high thermal conductivity, such as aluminum nitride or aluminum oxide. Generally, bond layer 202 may include any material having a thermal conductivity of at least 1.5 W/m·K, at least 15 W/m·K, at least 100 W/m·K, or at least 300 W/m·K. The greater thermal conductivity of bond layer 202 allows more heat to conduct through the layer stack above device layer 108 and be dissipated at heat sink 118. Bond layer 202 may have a thickness between about 20 nanometers and about 10 micrometers.

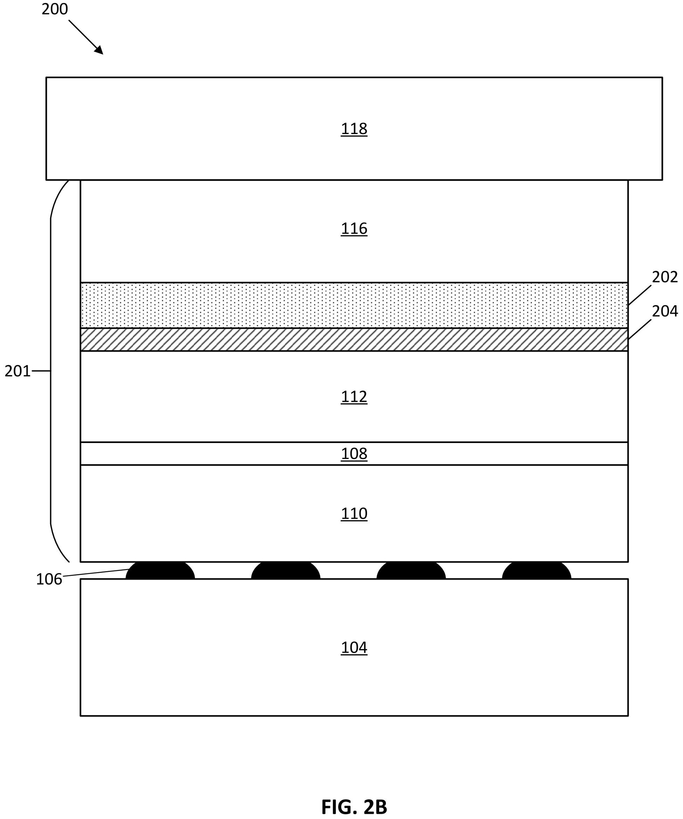

Figure 2B illustrates another cross-section of die 201 having bond layer 202 and a material layer 204 between bond layer 202 and frontside interconnect region 112, according to some embodiments. Material layer 204 may include another high thermally conductive material, such as any material with a thermal conductivity of at least 1.5 W/m·K, at least 15 W/m·K, at least 100 W/m·K, or at least 300 W/m·K. Example materials for material layer 204 include diamond, silicon carbide, aluminum nitride, aluminum oxide, or boron nitride. Material layer 204 may also include a metal material, such as copper.

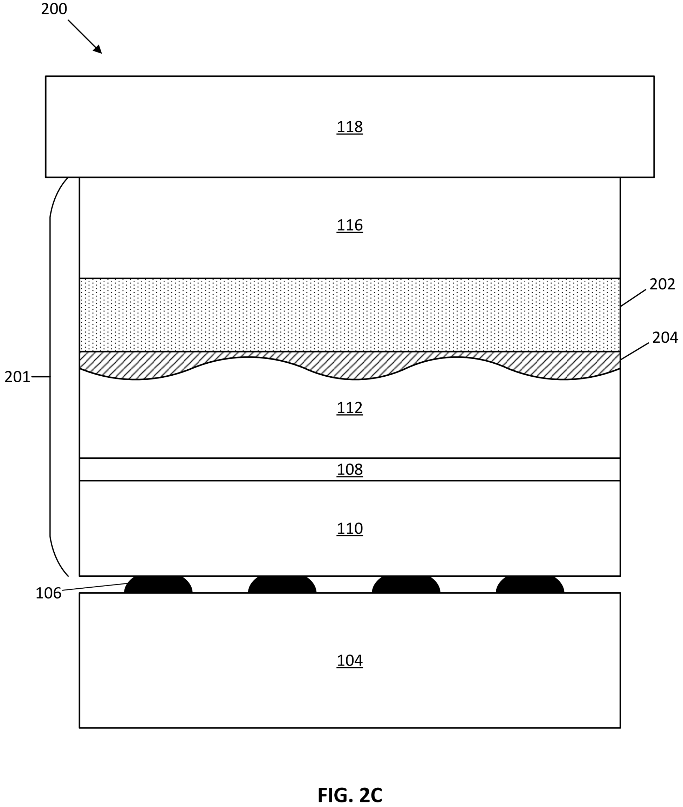

Figure 2C illustrates another cross-section of die 201 showing how a material layer 204 can be used to fill in the roughness of the topmost layer of frontside interconnect region 112, according to some embodiments. The topmost layer of frontside interconnect region 112 may have a roughness variation on the order of hundreds of nanometers (e.g., between 100 nm and 500 nm). Accordingly, material layer 204 may be first deposited and subsequently polished to provide a planar top surface over the roughness variation of frontside interconnect region 112. In some examples, the top surface of material layer 204 is polished using chemical mechanical polishing (CMP) to achieve a roughness variation of less than 1 nm or less than 2 nm. At least a portion of bond layer 202 may then be deposited on the top surface of material layer 204. Material layer 204 may have a greatest thickness between about 0.5 micrometer and about 5 micrometers, or at least thick enough to adequately fill in the roughness variation of the topmost layer of frontside interconnect region 112. A thinner material layer 204 is desired in situations where material layer 204 is a material with a relatively low thermal conductivity (e.g., less than 100 W/m·K)

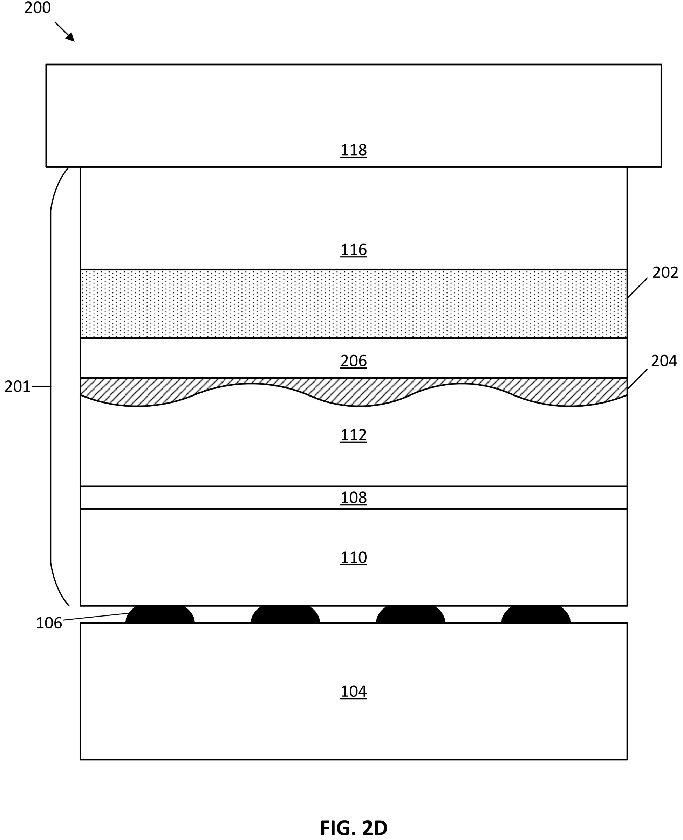

The inclusion of the thermally conductive materials at the bond interface may involve the use of electrically conductive materials, such as examples where bond layer 202 includes metal. Accordingly, parasitic capacitance could result from the existence of metal in bond layer 202 in proximity to metal lines within frontside interconnect layer 112. Figure 2D illustrates another cross-section of die 201 where a second material layer 206 is added between first material layer 204 and bond layer 202, according to some embodiments. Second material layer 206 may include a material layer having a low dielectric constant (such as a dielectric constant below 7.0) to help reduce the parasitic capacitance between bond layer 202 and any metal lines within frontside interconnect region 112. In some examples, second material layer 206 includes silicon dioxide, porous silicon dioxide, or airgaps.

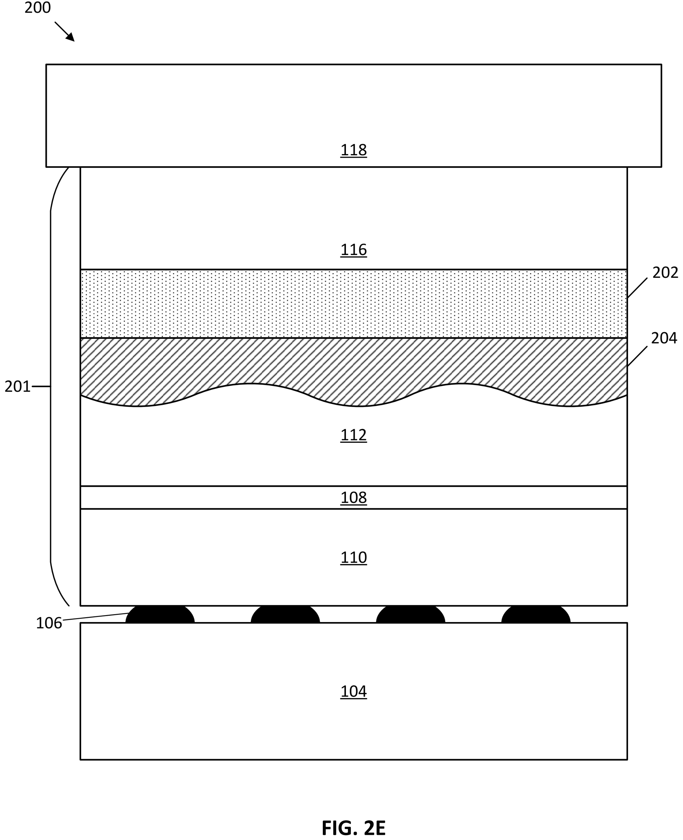

In some examples, the parasitic capacitance can be reduced by increasing the thickness of material layer 204 and having it be a non-metal material. Figure 2E illustrates another example of die 201 showing how material layer 204 may be made thicker to both fill in the roughness of the topmost layer of frontside interconnect layer 112 and provide sufficient separation between bond layer 202 and frontside interconnect layer 112. In this example, material layer 204 may have a greatest thickness that is greater than 5 micrometers, such as between 10 and 30 micrometers.

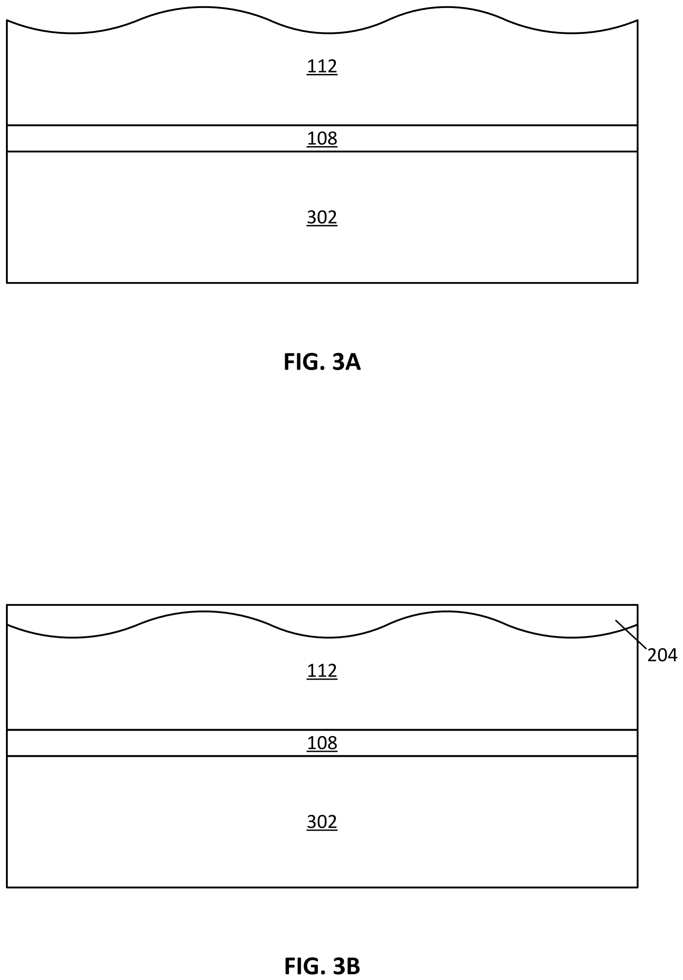

Figures 3A - 3F include cross-sectional views that collectively illustrate an example process for forming a die using a bond between materials with a relatively high thermal conductivity, according to some embodiments. The illustrated die structure may be part of a larger chip package, such as a system-on-chip package, that includes other dies and/or package elements not depicted. Example materials and process parameters are given, but other materials and process parameters may be used as well, as will be appreciated in light of this disclosure.

Figure 3A illustrates device layer 108 formed on a substrate 302 along with frontside interconnect region 112 formed over device layer 108, according to some embodiments. Substrate 302 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 302 can be a semiconductor-on-insulator substrate having device layer 108 over a buried insulator layer (e.g., silicon over silicon dioxide). Alternatively, substrate 302 can be a multilayer substrate or superlattice suitable for forming nanowires or nanoribbons (e.g., alternating layers of silicon and SiGe, or alternating layers indium gallium arsenide and indium phosphide). Any number of substrates can be used.

As noted above, frontside interconnect region 112 includes any number of interconnect layers stacked on one another. Each interconnect layer includes a dielectric material (e.g., silicon dioxide) and any number of conductive structures passing through the dielectric material to route signals to any of the devices in device layer 108. The top surface of the topmost layer of frontside interconnect region 112 may have a roughness variation of hundreds of nanometers, as depicted by the wavy topography.

Figure 3B illustrates the structure of Figure 3A following the formation of a first material layer 204 on a top surface of frontside interconnect region 112, according to some embodiments. As noted above, first material layer 204 may include a high thermally conductive material, such as any material with a thermal conductivity of at least 1.5 W/m·K, at least 15 W/m·K, at least 100 W/m·K, or at least 300 W/m·K. Example materials for material layer 204 include diamond, silicon carbide, aluminum nitride, aluminum oxide, or boron nitride. Material layer 204 may also include a metal material, such as copper. In some examples, the top surface of material layer 204 is polished using chemical mechanical polishing (CMP) to achieve a roughness variation of less than 1 nm or less than 2 nm. In some examples, first material layer 204 is any suitable dielectric material, such as silicon dioxide or silicon nitride. First material layer 204 may have a greatest thickness between about 0.5 micrometer and about 5 micrometers, or at least thick enough to adequately fill in the roughness variation of the topmost layer of frontside interconnect region 112.

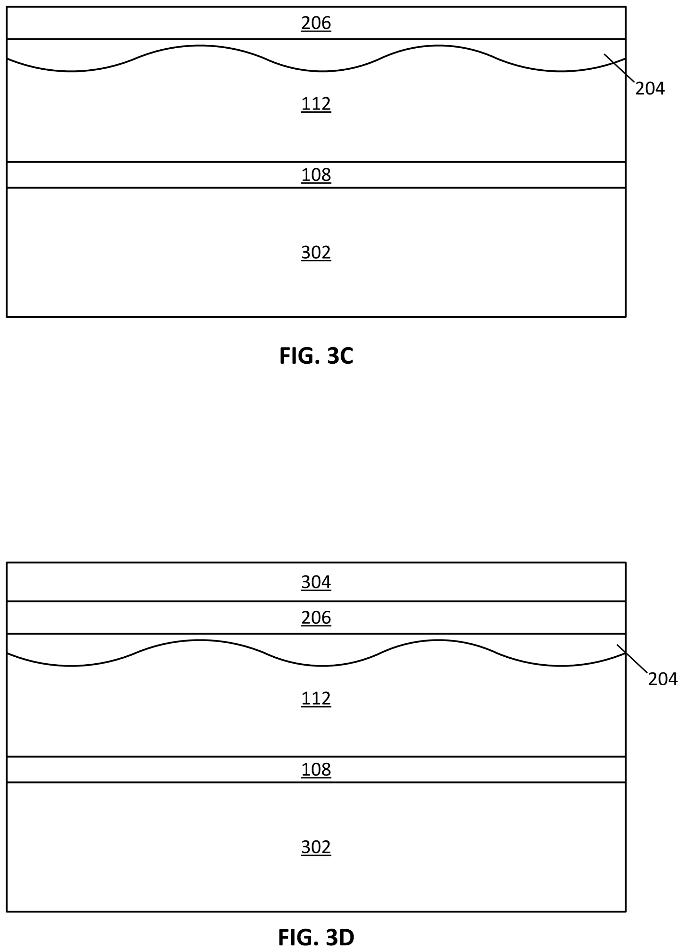

Figure 3C illustrates the structure of Figure 3B following the formation of a second material layer 206 on first material layer 204, according to some embodiments. Second material layer 206 may be provided to help reduce parasitic capacitance, and so may include a material having a relatively low dielectric constant (e.g., less than 7.0). In some examples, second material layer 206 is omitted. In some examples, first material layer 204 is deposited to a greater thickness, which can remove the need for second material layer 206. For example, first material layer 204 may be deposited to a thickness that is greater than 10 micrometers.

Figure 3D illustrates the structure of Figure 3C following the formation of a first bond interface layer 304 on second material layer 206 (or on first material layer 204 in the absence of second material layer 206), according to some embodiments. First bond interface layer 304 may have the same material composition as bond layer 202 discussed above. Thus, according to some embodiments, first bond interface layer 304 includes a thermally conductive material having a thermal conductivity of at least 1.5 W/m·K, at least 15 W/m·K, at least 100 W/m·K, or at least 300 W/m·K. First bond interface layer 304 may include a metal such as any of titanium, ruthenium, or cobalt.

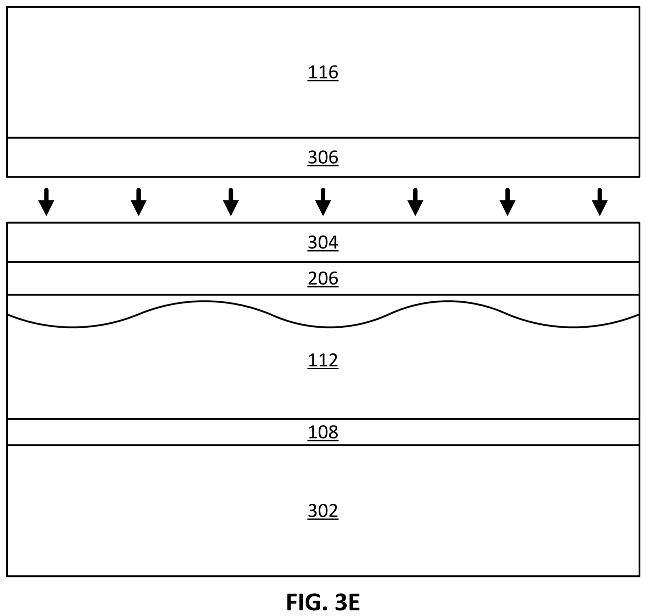

Figure 3E illustrates the structure of Figure 3D where a carrier substrate 116 having a second bond interface layer 306 is bonded to first bond interface layer 304, according to some embodiments. Second bond interface layer 306 may have substantially the same material composition as first bond interface layer 304. In some examples, each of first bond interface layer 304 and second bond interface layer 306 include titanium, ruthenium, or copper. A fusion bond may be used to seal the interface between first bond interface layer 304 and second bond interface layer 306.

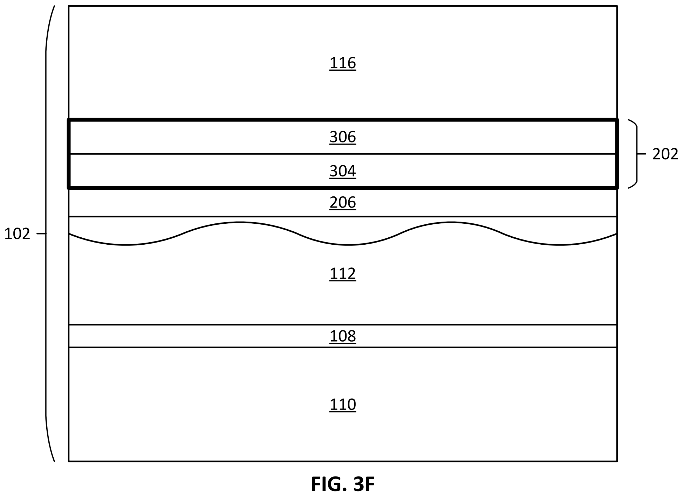

Figure 3F illustrates the structure of Figure 3E where the completed die 102 includes bond layer 202 composed of both first bond interface layer 304 and second bond interface layer 306, according to some embodiments. Once the bonding has been completed, substrate 302 is removed from beneath device layer 108 using any combination of polishing, grinding, or etching processes. Once substrate 302 has been removed, or at least he majority of substrate 302 has been removed, backside interconnect region 110 is formed in its place beneath device layer 108. As noted above, backside interconnect region 110 includes any number of interconnect layers stacked on one another. Each interconnect layer includes a dielectric material (e.g., silicon dioxide) and any number of conductive structures passing through the dielectric material. In some examples, the conductive structures within backside interconnect region 110 provide power and ground signals to the various devices in device layer 108.

### Example System

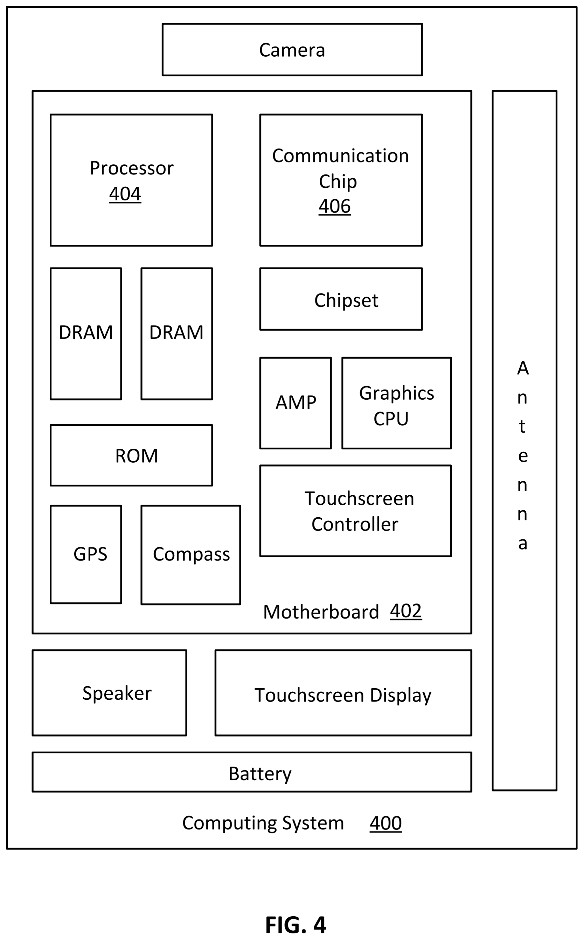

FIG. 4 is an example computing system implemented with one or more of the integrated circuit structures as disclosed herein, in accordance with some embodiments of the present disclosure. As can be seen, the computing system 400 houses a motherboard 402. The motherboard 402 may include a number of components, including, but not limited to, a processor 404 and at least one communication chip 406, each of which can be physically and electrically coupled to the motherboard 402, or otherwise integrated therein. As will be appreciated, the motherboard 402 may be, for example, any printed circuit board (PCB), whether a main board, a daughterboard mounted on a main board, or the only board of system 400, etc.

Depending on its applications, computing system 400 may include one or more other components that may or may not be physically and electrically coupled to the motherboard 402. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 400 may include one or more die structures configured in accordance with an example embodiment, such as a die having a bond interface with a carrier substrate that uses a high thermal conductivity material. In some embodiments, multiple functions can be integrated into one or more chips (e.g., for instance, note that the communication chip 406 can be part of or otherwise integrated into the processor 404).

The communication chip 406 enables wireless communications for the transfer of data to and from the computing system 400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 406 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 400 may include a plurality of communication chips 406. For instance, a first communication chip 406 may be dedicated to shorter range wireless communications such as Wi-Fi and Bluetooth and a second communication chip 406 may be dedicated to longer range wireless communications such as GPS, EDGE, GPRS, CDMA, WiMAX, LTE, Ev-DO, and others.

The processor 404 of the computing system 400 includes an integrated circuit die packaged within the processor 404. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 406 also may include an integrated circuit die packaged within the communication chip 406. In accordance with some such example embodiments, the integrated circuit die of the communication chip includes one or more semiconductor devices as variously described herein. As will be appreciated in light of this disclosure, note that multi-standard wireless capability may be integrated directly into the processor 404 (e.g., where functionality of any chips 406 is integrated into processor 404, rather than having separate communication chips). Further note that processor 404 may be a chip set having such wireless capability. In short, any number of processor 404 and/or communication chips 406 can be used. Likewise, any one chip or chip set can have multiple functions integrated therein.

In various implementations, the computing system 400 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 400 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is a die that includes a plurality of semiconductor devices, an interconnect region above the plurality of semiconductor devices and having a plurality of interconnect layers, a bond layer over the interconnect region, and a substrate on the bond layer. The bond layer has a thermal conductivity of at least 5 W/m·K.

Example 2 includes the die of Example 1, further comprising a material layer between the bond layer and the interconnect region.

Example 3 includes the die of Example 2, wherein the material layer comprises diamond.

Example 4 includes the die of Example 2, wherein the material layer comprises silicon and carbon.

Example 5 includes the die of Example 2, wherein the material layer comprises copper.

Example 6 includes the die of any one of Examples 2-5, wherein the material layer has a thickness between about 0.5 µm and about 5 µm.

Example 7 includes the die of any one of Examples 2-6, wherein the bond layer is directly on a top surface of the material layer.

Example 8 includes the die of any one of Examples 2-7, wherein the material layer is a first material layer, and the die further comprises a second material layer between the first material layer and the bond layer, the second material layer having a dielectric constant of less than 5.0.

Example 9 includes the die of any one of Examples 2-8, wherein the material layer has a substantially planar top surface with a roughness variation of less than 1 nm.

Example 10 includes the die of any one of Examples 2-9, wherein the material layer has a thermal conductivity of at least 1.5 W/m·K.

Example 11 includes the die of any one of Examples 1-10, wherein the substrate has a thickness between 50 µm and 800 µm.

Example 12 includes the die of any one of Examples 1-11, wherein the bond layer comprises a metal.

Example 13 includes the die of Example 12, wherein the bond layer comprises titanium, ruthenium, or copper.

Example 14 includes the die of any one of Examples 1-13, wherein the interconnect region is a first interconnect region and the die further comprises a second interconnect region below the plurality of semiconductor devices.

Example 15 is an electronic device that includes a chip package having one or more dies. At least one of the one or more dies includes a device layer comprising one or more semiconductor devices, one or more interconnect layers above the device layer, a material layer on a top surface of a topmost interconnect layer of the one or more interconnect layers, a bond layer over the material layer, and a substrate bonded to the bond layer. The bond layer has a thermal conductivity of at least 5 W/m·K and the material layer has a thermal conductivity of at least 1.5 W/m·K.

Example 16 includes the electronic device of Example 15, wherein the material layer comprises diamond.

Example 17 includes the electronic device of Example 15, wherein the material layer comprises silicon and carbon.

Example 18 includes the electronic device of Example 15, wherein the material layer comprises copper.

Example 19 includes the electronic device of any one of Examples 15-18, wherein the material layer has a thickness between about 0.5 µm and about 5 µm.

Example 20 includes the electronic device of any one of Examples 15-19, wherein the bond layer is directly on a top surface of the material layer.

Example 21 includes the electronic device of any one of Examples 15-20, wherein the substrate has a thickness between 50 µm and 800 µm.

Example 22 includes the electronic device of any one of Examples 15-21, wherein the bond layer comprises a metal.

Example 23 includes the electronic device of Example 22, wherein the bond layer comprises titanium, ruthenium, or copper.

Example 24 includes the electronic device of any one of Examples 15-23, wherein the material layer is a first material layer, and the at least one of the one or more dies further comprises a second material layer between the first material layer and the bond layer, the second material layer having a dielectric constant of less than 5.0.

Example 25 includes the electronic device of any one of Examples 15-24, wherein the material layer has a substantially planar top surface with a roughness variation of less than 1 nm.

Example 26 includes the electronic device of any one of Examples 15-25, wherein the at least one of the one or more dies further comprises one or more interconnect layers below the plurality of semiconductor devices.

Example 27 includes the electronic device of any one of Examples 15-26, further comprising a printed circuit board, wherein the chip package is attached to the printed circuit board.

Example 28 is a die that includes a device layer comprising one or more semiconductor devices, an interconnect region above the plurality of semiconductor devices and having a plurality of interconnect layers, a first material layer on a top surface of a topmost interconnect layer of the plurality of interconnect layers, a second material layer on a top surface of the first material layer, a metal layer on a top surface of the second material layer, and a substrate on the metal layer. The first material layer has a thermal conductivity of at least 1.5 W/m·K. The second material layer has a dielectric constant of less than 7.0.

Example 29 includes the die of Example 28, wherein the first material layer comprises diamond.

Example 30 includes the die of Example 28, wherein the first material layer comprises silicon and carbon.

Example 31 includes the die of Example 28, wherein the first material layer comprises copper.

Example 32 includes the die of any one of Examples 28-31, wherein the first material layer has a thickness of less than 1 µm.

Example 33 includes the die of any one of Examples 28-32, wherein the second material layer has a greater thickness than the first material layer.

Example 34 includes the die of any one of Examples 28-33, wherein the substrate has a thickness between 50 µm and 800 µm.

Example 35 includes the die of any one of Examples 28-34, wherein the metal layer comprises titanium, ruthenium, or copper.

Example 36 includes the die of any one of Examples 28-35, wherein the interconnect region is a first interconnect region and the die further comprises a second interconnect region below the one or more semiconductor devices.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. A die, comprising:
a plurality of semiconductor devices;
an interconnect region above the plurality of semiconductor devices, the interconnect region comprising a plurality of interconnect layers;
a bond layer over the interconnect region, the bond layer having a thermal conductivity of at least 1.5
W/m·K; and
a substrate on the bond layer.

2. The die of claim 1, further comprising a material layer between the bond layer and the interconnect region.

3. The die of claim 2, wherein the material layer comprises diamond.

4. The die of claim 2, wherein the material layer comprises silicon and carbon.

5. The die of claim 2, wherein the material layer comprises copper.

6. The die of any one of claims 2 through 5, wherein the material layer has a thickness between about 0.5 µm and about 5 µm.

7. The die of any one of claims 2 through 6, wherein the bond layer is directly on a top surface of the material layer.

8. The die of any one of claims 2 through 7, wherein the material layer is a first material layer, and the die further comprises a second material layer between the first material layer and the bond layer, the second material layer having a dielectric constant of less than 5.0.

9. The die of any one of claims 2 through 8, wherein the material layer has a substantially planar top surface with a roughness variation of less than 1 nm.

10. The die of any one of claims 2 through 9, wherein the material layer has a thermal conductivity of at least 1.5 W/m·K.

11. The die of any one of claims 1 through 10, wherein the substrate has a thickness between 50 µm and 800 µm.

12. The die of any one of claims 1 through **11,** wherein the bond layer comprises a metal.

13. The die of claim 12, wherein the bond layer comprises titanium, ruthenium, or copper.

14. The die of any one of claims 1 through 13, wherein the interconnect region is a first interconnect region and the die further comprises a second interconnect region below the plurality of semiconductor devices.

15. The die of any one of claims 1 through 14, wherein the bond layer has a thermal conductivity of at least 5 W/m·K.
